# FASCICULE DE BREVET EUROPEEN

(11) **EP 1 136 829 B1**
(45) Date de publication et mention de la délivrance du brevet: **14.07.2004**
(21) Numéro de dépôt: 01430011.5
(22) Date de dépôt: 22.03.2001
(51) Int. Cl.: G01R 21/133

(54) **Procédé et dispositif de mesure de la consommation électrique d'un élément connecté a un réseau de distribution d'électricité**
Verfahren und Vorrichtung zum Messen des Verbrauchs eines Elementes in einem Elektrizitätsnetz
Method and apparatus for measuring the consumption of an element of an electrical network

(30) Priorité: 22.03.2000 FR 0003620
(43) Date de publication de la demande: 26.09.2001
(73) Titulaire: Watteco, 83160 La Valette du Var (FR)
(72) Inventeur: Bertrand, Paul, 83200 Toulon (FR)
(74) Mandataire: Marchand, André

(56) Documents cités:
- FR-A- 2 680 875
- US-A- 4 858 141
- US-A- 5 483 153

## Description

La présente invention concerne un procédé de mesure de la consommation électrique d'appareils électriques connectés à un réseau de distribution d'électricité.

La maîtrise de la consommation d'énergie, notamment de la consommation d'énergie électrique, est un problème auquel le consommateur est de plus en plus sensible. Il existe ainsi à l'heure actuelle un besoin clairement formulé par les fournisseurs d'électricité de pouvoir présenter à leurs abonnés, qu'ils soient des particuliers ou des entreprises, un relevé détaillé de la consommation électrique des appareils électriques qu'ils utilisent. Un tel relevé indiquerait le coût de la consommation électrique et le temps d'utilisation de chaque appareil sur la période facturée. Diverses données statistiques comme le coût horaire d'utilisation d'un appareil, la durée journalière moyenne d'utilisation de l'appareil, le coût total de la consommation électrique de l'appareil depuis sa mise en service, etc. pourraient également être présentées aux abonnés.

A l'heure actuelle, le procédé connu le moins coûteux à mettre en oeuvre pour atteindre cet objectif est basé sur une mesure continue de la puissance instantanée globale consommée sur le réseau, et sur une détection des mises sous tension et hors tension de chaque appareil par observation des variations de la puissance consommée. Une fois les mises sous tension et hors tension de chaque appareil détectées, il est aisé d'en déduire la consommation électrique de chaque appareil, qui est égale au produit de la puissance consommée et du temps de fonctionnement de l'appareil (énergie électrique).

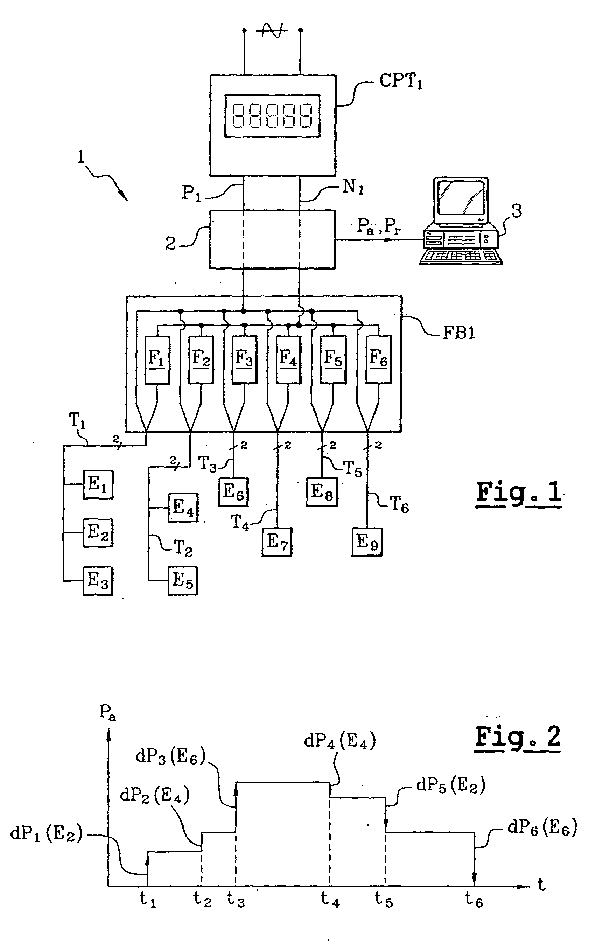

La figure 1 illustre la mise en oeuvre de ce procédé classique et représente de façon schématique un réseau de distribution d'électricité 1. Le réseau 1, de type monophasé, comprend un compteur électrique CPT1, une ligne de phase P1 et une ligne de neutre N1 et se divise ici en six sections T1 à T6 par l'intermédiaire d'une boîte à fusibles FB1 comprenant des fusibles F1 à F6. Des appareils électriques E1 à E3 sont connectés à la section T1, des appareils E4 et E5 sont connectés à la section T2, et des appareils E6, E7, E8, E9 sont connectés respectivement aux sections T3, T4, T5, T6. Un wattmètre numérique 2 relié à un moyen de calcul 3 comme un micro-ordinateur, est agencé entre le compteur CPT1 et le point de division du réseau. Le wattmètre 2 délivre de façon récurrente, par exemple tous les dixièmes de seconde, la puissance instantanée consommée, qui comprend la puissance active Pa (UIcosϕ) et la puissance réactive (UIsinϕ), U étant l'amplitude de la tension alternative sur le réseau, I l'amplitude du courant, et ϕ le déphasage courant/tension.

Chaque appareil présentant une puissance consommée déterminée, mesurée au cours d'une phase d'apprentissage, les variations des puissances active Pa et réactive Pb consommées permettent au micro-ordinateur 3 d'identifier les appareils mis sous tension ou hors tension. Ainsi, suivant l'exemple illustré en figure 2, une variation positive dP1, à un instant t1, de la puissance active Pa consommée permet de savoir que l'appareil E2, par exemple un aspirateur, dont la consommation est égale à la variation dP1, vient d'être mis sous tension. A des instants t2 et t3, des variations positives dP2 et dP3 de la puissance consommée permettent de savoir que les appareils E4 et E6, par exemple une lampe et un four, ont également été mis sous tension. A un instant t4, une variation négative dP4 égale à dP1 permet de savoir que l'appareil E4 vient d'être mis hors tension, et des variations négatives dP5 et dP6 à des instants t5 et t6, respectivement égales à dP1 et dP3, permettent de savoir que les appareils E2 et E6 ont été mis hors tension, etc..

Des exemples de procédés d'identification d'appareils électriques basés sur une mesure de consommation électrique sont décrits par les brevets US 5 483 153, US 4 858 141, et FR 2 680 875. En particulier, le brevet US 5 483 153 décrit en relation avec ses figures 2 à 6 diverses "signatures" de consommation électrique, ou variations de la courbe de puissance, exprimées en Watt et dont la détermination nécessite une mesure précise et complexe d'une consommation instantanée, ou énergie dissipée.

Bien que satisfaisant en théorie, les procédés d'identification d'appareils par mesure de puissance s'avèrent délicats à mettre en oeuvre et offrent un pourcentage élevé d'erreurs d'identification des appareils lorsque ceux-ci présentent sensiblement la même consommation ou le même profil de consommation au démarrage. On a cru pouvoir corriger cet inconvénient en observant les variations de la puissance réactive (deux appareils ayant la même consommation en puissance active n'ayant pas nécessairement la même consommation en puissance réactive) mais l'amélioration constatée n'est que partielle. Ainsi, deux appareils électroménagers complexes, par exemple une machine à laver le linge et une machine à laver la vaisselle, comprenant chacun divers éléments électriques comme des résistances, un moteur, des circuits électroniques, peuvent comporter deux éléments électriques similaires et être confondus.

La présente invention vise à pallier cet inconvénient.

Plus particulièrement, un objectif de la présente invention est de prévoir un procédé qui soit plus fiable que le procédé décrit ci-dessus en ce qui concerne l'identification des appareils mis sous tension ou hors tension.

Plus particulièrement, la présente invention vise un moyen d'analyse supplémentaire, autre que la variation de la puissance consommée, permettant l'identification des appareils mis sous tension ou hors tension.

Cet objectif est atteint par un procédé de mesure de la consommation électrique d'au moins un élément électrique connecté à un réseau de distribution d'électricité, comprenant une étape récurrente de mesure de la puissance instantanée globale consommée sur le réseau et au moins une étape de détection d'une mise sous tension ou hors tension de l'élément électrique, dans lequel l'étape de détection de la mise sous tension ou hors tension de l'élément électrique comprend une étape de détection d'au moins un signal électrique haute fréquence représentatif de l'élément électrique et indépendant de sa consommation électrique, généré sur le réseau au moment de la mise sous tension ou la mise hors tension de l'élément électrique.

Selon un mode de réalisation, le signal électrique est généré naturellement par l'élément électrique, et constitue une impulsion électrique parasite.

Selon un mode de réalisation, le signal électrique est produit par un circuit générateur de signaux haute fréquence associé à l'élément électrique, à la mise sous tension et/ou à la mise hors tension de l'élément électrique.

Selon un mode de réalisation, l'étape de détection du signal haute fréquence comprend une étape d'enregistrement du signal haute fréquence sous une forme numérique et une étape d'identification du signal haute fréquence.

Selon un mode de réalisation, l'étape de détection de la mise sous tension ou hors tension de l'élément électrique comprend en outre une étape de vérification consistant à comparer la variation de la puissance instantanée consommée sur le réseau à la mise sous tension ou hors tension de l'élément électrique avec une valeur prédéterminée de puissance consommée par l'élément électrique.

Selon un mode de réalisation, l'étape de vérification comprend une étape de comparaison de la variation de puissance active consommée sur le réseau avec une valeur prédéterminée de puissance active consommée par l'élément électrique, et une étape de comparaison de la variation de puissance réactive consommée sur le réseau avec une valeur prédéterminée de puissance réactive consommée par l'élément électrique.

Selon un mode de réalisation, l'élément électrique est un élément d'un appareil électrique comprenant une pluralité d'éléments électriques susceptibles d'être mis sous tension ou hors tension indépendamment les uns des autres.

La présente invention concerne également un dispositif de mesure de la consommation électrique d'au moins un élément électrique connecté à un réseau de distribution d'électricité, comprenant des moyens de mesure de la puissance instantanée globale consommée sur le réseau et des moyens de détection d'une mise sous tension ou hors tension de l'élément électrique, dans lequel les moyens de détection comprennent des moyens de détection d'un signal électrique haute fréquence représentatif de l'élément électrique et indépendant de sa consommation électrique, généré sur le réseau au moment de la mise sous tension ou hors tension de l'élément électrique.

Selon un mode de réalisation, le dispositif comprend des moyens pour enregistrer sous forme numérique des signaux haute fréquence apparaissant sur le réseau, en attribuant à chaque signal haute fréquence mémorisé la date et l'heure de sa détection.

Selon un mode de réalisation, les moyens pour enregistrer sont agencés pour enregistrer également des valeurs de puissance instantanée globale consommée sur le réseau mesurées par les moyens de mesure, en attribuant à chaque valeur mémorisée la date et l'heure de la mesure. Selon un mode de réalisation, les moyens pour enregistrer sont agencés pour enregistrer continuellement dans une mémoire tampon le profil de la tension ou du courant dans le réseau après filtrage passe-haut, selon une fenêtre temporelle d'observation de largeur déterminée, et pour enregistrer le contenu de la mémoire tampon dans une mémoire de masse quand un signal haute fréquence apparaît dans la fenêtre d'observation.

Selon un mode de réalisation, les moyens pour enregistrer prennent la forme d'un dispositif d'enregistrement autonome agencé pour délivrer sur une sortie le contenu de la mémoire de masse et effacer ensuite le contenu de la mémoire de masse, les moyens de mesure étant intégrés dans le dispositif d'enregistrement autonome ou reliés à ce dernier par un canal de transmission de données.

Selon un mode de réalisation, le dispositif comprend un moyen de calcul connecté aux moyens pour enregistrer, agencé pour identifier les signaux haute fréquence enregistrés et calculer la consommation de l'élément électrique à partir des dates de mise sous tension et/ou de mise hors tension de l'élément électrique et des variations de la puissance consommée.

Selon un mode de réalisation, les moyens de détection de la mise sous tension et de la mise hors tension de l'élément électrique comprennent un circuit d'émission de signal haute fréquence associé à l'élément électrique, agencé pour générer un signal haute fréquence sur le réseau à la mise sous tension et/ou à la mise hors tension de l'élément électrique.

Selon un mode de réalisation, le dispositif comprend au moins un dispositif répéteur connecté en un point déterminé du réseau, agencé pour amplifier un signal haute fréquence émis par un dispositif électrique éloigné des moyens de détection du signal haute fréquence.

Bien entendu, l'expression "mis sous tension" désigne dans la présente demande le fait que l'élément ou l'appareil considéré soit activé (démarrage, allumage, éclairage...) et non seulement le fait que la prise électrique de l'élément soit branchée sur le réseau.

Ces objets, caractéristiques et avantages ainsi que d'autres de la présente invention seront exposés plus en détail dans la description suivante du procédé de l'invention et d'un exemple de réalisation d'un dispositif de mesure de consommation mettant en oeuvre ce procédé, en relation avec les figures jointes parmi lesquelles :
- la figure 1 précédemment décrite représente un réseau de distribution d'électricité,
- la figure 2 est un diagramme de consommation de puissance active consommée dans le réseau de la figure 1 et illustre un procédé classique de mesure de la consommation électrique d'éléments électriques connectés au réseau,
- la figure 3 représente un signal électrique haute fréquence émis par un élément électrique à sa mise sous tension ou à sa mise hors tension,
- la figure 4 représente un réseau de distribution d'électricité comprenant un dispositif de mesure de consommation selon l'invention,
- la figure 5 est le schéma électrique d'un dispositif de détection et de stockage de signaux haute fréquence représenté schématiquement en figure 4, et
- la figure 6 représente la structure d'une mémoire tampon représentée sous forme de bloc en figure 5.

### Description du procédé de l'invention

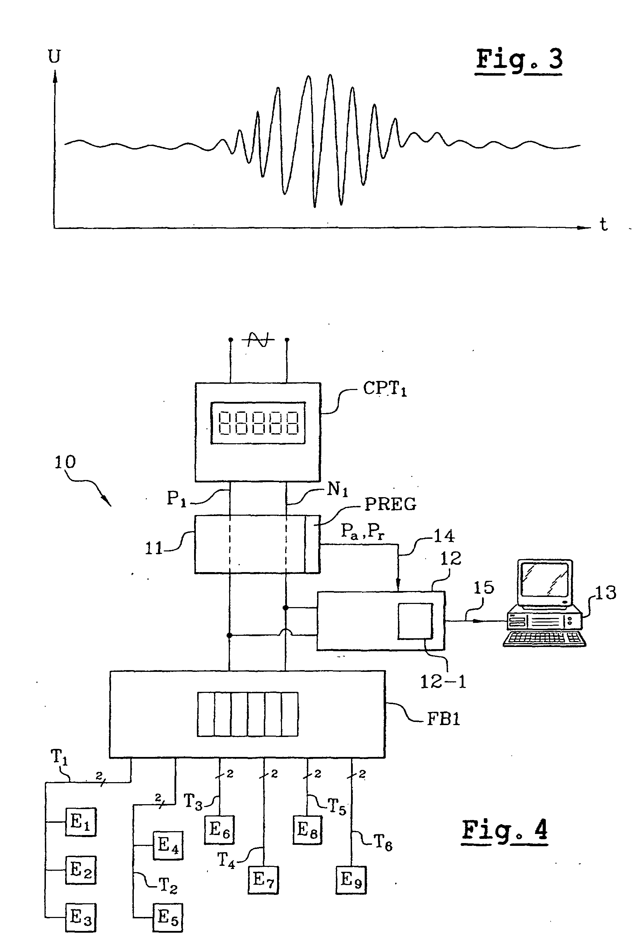

Il est connu que tout élément électrique, notamment résistance, moteur, pompe, transformateur, ampoule électrique, circuit électrique ou électronique... présente vu de son entrée d'alimentation électrique une impédance complexe et génère, à sa mise sous tension et à sa mise hors tension, un signal électrique parasite haute fréquence de très courte durée, ayant une origine électromagnétique. Un tel signal, qui est indépendant de la consommation électrique de l'élément électrique, prend la forme d'une impulsion alternative d'une fréquence de l'ordre de 20 MHz et d'une durée de l'ordre de 250 nanosecondes, dont amplitude peut aller de la dizaine de millivolt jusqu'à quelques volt (sous une tension de 220 Volt) selon la composante réactive (self ou capacité) de l'élément et la puissance qu'il absorbe. Pour fixer les idées, on a représenté sur la figure 3 la forme du signal électrique parasite émis par un fer à repasser lors de sa mise sous tension, détectée au moyen d'un oscilloscope.

Une telle impulsion électrique forme une sorte de "signature" de l'élément, représentative de sa mise sous tension ou de sa mise hors tension. En pratique deux éléments de même nature et de puissance similaire ne présentent jamais la même signature, car celle-ci dépend de divers facteurs comme la longueur des câbles reliant les éléments au réseau électrique, le type d'interrupteur assurant leur mise sous tension, la longueur de la section de réseau à laquelle ils sont raccordés, etc..

La présente invention propose de tirer parti de l'existence d'un tel signal haute fréquence pour détecter les mises sous tension ou hors tension d'appareils électriques ou éléments de ces appareils. De façon générale, la détection de la signature impulsionnelle émise par un appareil ou un élément d'appareil constitue un critère d'identification plus sûr et plus efficace qu'une simple analyse de la puissance consommée.

Toutefois, de préférence, l'étape de détection et de reconnaissance de chaque impulsion émise sur le réseau est complétée, à titre de vérification, par une étape classique de comparaison de la variation de la puissance instantanée consommée avec la puissance nominale de l'appareil identifié, mesurée de préférence en puissance active Pa et en puissance réactive Pr. Cette étape complémentaire, constituant dans le procédé antérieur le seul moyen de reconnaissance d'un appareil, permet de lever, le cas échéant, une incertitude sur la signature. Comme on le verra plus loin, cette étape permet surtout de ne pas stocker en mémoire des impulsions parasites émises cycliquement par certains appareils, ne correspondant pas à des mises sous tension ou hors tension.

La détection et l'identification d'un signal haute fréquence émis sur le réseau et formant une signature impulsionnelle est donc une étape essentielle qui distingue le procédé de l'invention de l'art antérieur. Une telle détection comprend une étape de détection proprement dite de l'impulsion et une étape d'identification de l'impulsion par comparaison avec un modèle d'impulsion préenregistré au cours d'une phase d'apprentissage.

Dans un premier temps, la demanderesse a procédé à divers essais préliminaires visant à vérifier le bien fondé et la faisabilité du procédé. Les essais ont été conduits au moyen d'un oscilloscope numérique connecté à un réseau électrique par l'intermédiaire d'un transformateur isolateur passe-haut. A ce réseau étaient branchés trente appareils environ, notamment des lampes et divers appareils électroménager. Le signal délivré par l'oscilloscope numérique était analysé par un micro-ordinateur. Parallèlement, un wattmètre numérique délivrait au micro-ordinateur la puissance instantanée globale consommée sur le réseau, avec une fréquence de mesure de l'ordre de la seconde. Au cours d'une phase d'apprentissage et de mémorisation des profils d'impulsions, il est apparu qu'un appareil électrique complexe comme une machine à laver peut générer une dizaine de signatures différentes selon le cycle de lavage en cours (prélavage, chauffage, lavage, vidange, rinçage...) en raison des divers éléments électriques présents dans un tel appareil (résistances, moteur, pompe, électrovanne, programmateur...). D'autres appareils émettent par contre une signature unique. Une fois les diverses signatures enregistrées dans le micro-ordinateur, formant ensemble une base de données de reconnaissance d'impulsions, la phase d'évaluation du procédé a pu être réalisée et les impulsions détectées sur le réseau ont été comparées par le micro-ordinateur aux impulsions préenregistrées, au moyen d'un algorithme de corrélation de signaux en soi de type classique. Le taux de réussite obtenu, c'est-à-dire le pourcentage d'identifications non entachées d'erreur, a été de l'ordre de 90 %, soit un résultat excellent pour un système expérimental utilisant une base de données de taille réduite pour la reconnaissance des impulsions.

Les caractéristiques essentielles du procédé de l'invention étant décrites, un objectif de l'invention est maintenant de prévoir un système permettant de mettre en oeuvre ce procédé chez l'abonné sans qu'il soit nécessaire d'utiliser un appareil de laboratoire comme un oscilloscope.

### Mise en oeuvre du procédé de l'invention

La figure 4 représente un réseau de distribution d'électricité 10 conforme à celui de la figure 1. Le réseau 10, ici monophasé, comprend un compteur électrique CPT1, une ligne de phase P1 et une ligne de neutre N1, et se divise en six sections T1 à T6 par l'intermédiaire d'une boîte à fusibles FB1. Des appareils électriques E1 à E9 sont connectés aux sections T1 à T6, comme décrit au préambule.

Le procédé de l'invention est mis en oeuvre au moyen d'un dispositif de mesure comprenant un wattmètre numérique 11, un dispositif 12 de détection et de stockage d'impulsions, et un micro-ordinateur 13 qui peut être le micro-ordinateur de l'abonné (par exemple le micro-ordinateur familial d'un particulier ou un ordinateur quelconque d'une entreprise). Le wattmètre 11 est connecté entre le compteur CPT1 et le point de division du réseau. Le dispositif 12 est connecté ici, comme le wattmètre, entre le compteur CPT1 et le point de division du réseau, mais peut également être connecté en tout point du réseau car les impulsions haute fréquence émises par les appareils se propagent dans toutes les sections du réseau.

Le dispositif 12 stocke dans une mémoire de masse 12-1 les impulsions haute fréquence apparaissant sur le réseau, engendrées par les mises sous tension et les mises hors tension des appareils E1 à E9 et leurs éléments constitutifs. Chaque impulsion est stockée sous forme numérique avec attribution d'une date. Une date comprend l'année, le mois, le jour, et l'heure à laquelle l'impulsion a été détectée et stockée, de préférence avec une précision de l'ordre du centième de seconde. Selon un aspect optionnel mais avantageux de l'invention, le dispositif 12 stocke également dans la mémoire de masse 12-1 des valeurs de puissance active consommée Pa et de puissance réactive consommée Pr délivrées par le wattmètre 11. Ici, les valeurs Pa, Pr sont disponibles dans un registre PREG du wattmètre 11 et sont lues par le dispositif 12 au moyen d'une liaison parallèle 14. Les valeurs Pa, Pr sont lues dans le registre PREG à intervalles réguliers, par exemple toutes les secondes, et sont stockées dans la mémoire de masse 12-1 avec attribution de la date de stockage. Le contenu de la mémoire 12-1 est transféré par le dispositif 12 au micro-ordinateur 13, sur demande de ce dernier, par l'intermédiaire d'une liaison série 15 de type filaire ou radioélectrique. Après le transfert des données, le dispositif 12 efface le contenu de la mémoire 12-1. De préférence, la capacité de stockage de la mémoire de masse 12-1 est suffisante pour enregistrer des impulsions détectées et les valeurs de puissance Pa, Pr sur une période de plusieurs semaines en cas d'arrêt du micro-ordinateur 13, par exemple lorsque l'abonné est absent.

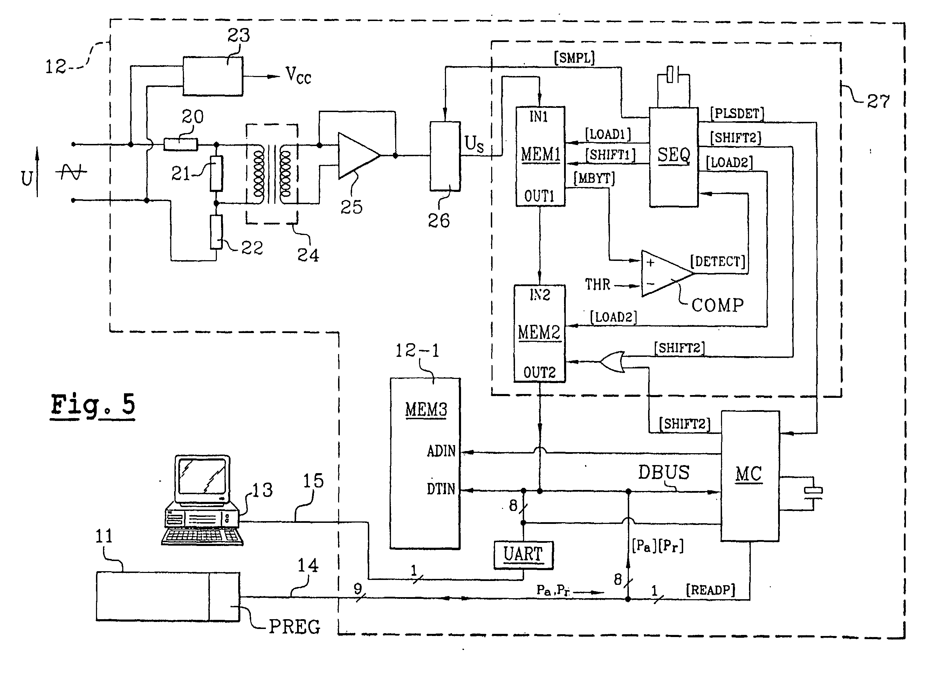

Un exemple de réalisation du dispositif 12 est illustré sur la figure 5. Le dispositif 12 reçoit la tension U du secteur qui est appliquée à un pont diviseur de tension comprenant trois résistances 20, 21, 22, ainsi qu'à un circuit d'alimentation 23 délivrant la tension d'alimentation continue Vcc du dispositif 12. La tension atténuée présente aux bornes de la résistance 21 est appliquée au primaire d'un transformateur isolateur passe-haut 24 ayant une fréquence de coupure de l'ordre de 150 KHz. Le secondaire du transformateur 24 est appliqué en entrée d'un amplificateur suiveur 25 dont la sortie est appliquée à un convertisseur analogique-numérique 26. La sortie du convertisseur 26, ici sur 8 bits, délivre un signal échantillonné Us envoyé à un circuit de mémorisation 27.

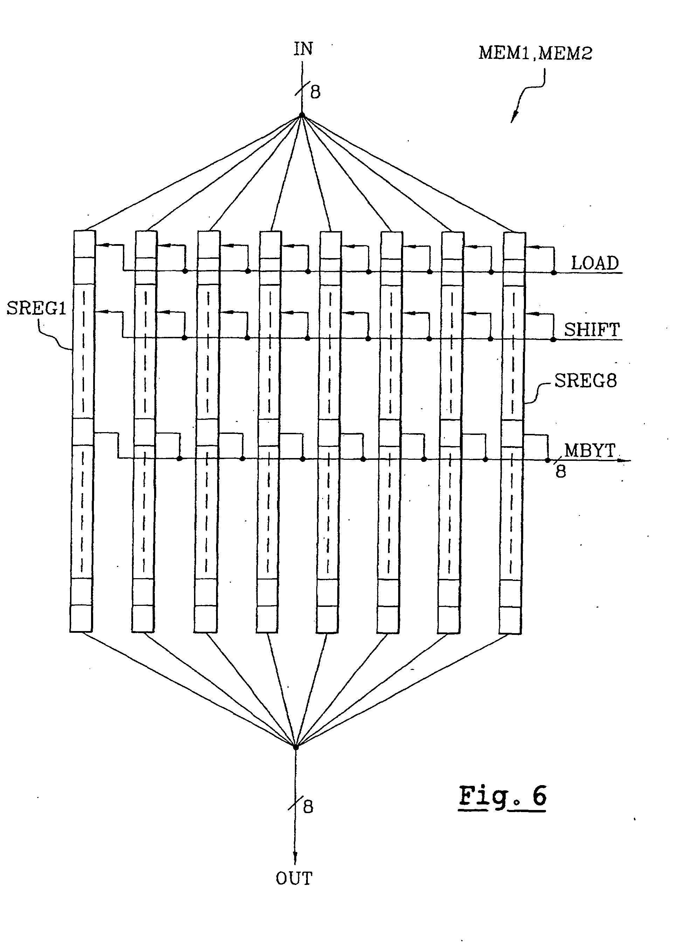

Le circuit de mémorisation 27 est un circuit logique ayant une fréquence d'horloge rapide, réalisé par exemple sous forme de circuit intégré monolithique de type FPGA. Le circuit de mémorisation 27 comprend un circuit séquenceur SEQ pourvu d'un oscillateur à quartz oscillant à une fréquence de l'ordre de 100 MHz, une mémoire tampon MEM1, ici de 256 octets, une mémoire tampon auxiliaire MEM2 de 256 octets également et un comparateur logique COMP. Les mémoires MEM1 et MEM2 sont des mémoires à décalage pilotées respectivement par des signaux de chargement LOAD1, LOAD2 et des signaux de décalage SHIFT1, SHIFT2 délivrés par le circuit SEQ. Le séquenceur SEQ applique au convertisseur 26 un signal d'échantillonnage SMPL de 100 MHz et le signal échantillonné Us est appliqué sur l'entrée IN1 de la mémoire MEM1. La sortie OUT1 de la mémoire MEM1 est connectée à l'entrée IN2 de la mémoire MEM2. Le comparateur COMP reçoit sur une première entrée un mot binaire THR formant un seuil de détection et sur une deuxième entrée un mot binaire MBYT prélevé dans la mémoire à décalage MEM1, de préférence un mot se situant vers le milieu de la mémoire, par exemple le mot de rang 128. La figure 6 représente à titre d'exemple un mode de réalisation des mémoires MEM1, MEM2, par juxtaposition en parallèle de huit registres à décalage SREG1 à SREG8 de 256 bits chacun, huit cellules en parallèle de chacun des registres formant un ligne mémoire.

Le dispositif 12 comprend également un microcontrôleur MC et une mémoire MEM3 constituant la mémoire de masse 12-1, par exemple une mémoire FLASH, dont l'entrée d'adresse ADIN est pilotée par le microcontrôleur MC. Le microcontrôleur MC possède son propre circuit générateur d'horloge et fonctionne à une fréquence plus faible que le circuit d'acquisition 27, par exemple 20 MHz. Le bus de données DBUS du microcontrôleur MC est connecté à l'entrée de données DTIN de la mémoire MEM3 et à la sortie de la mémoire auxiliaire MEM2 du circuit 27. Le bus de données DBUS est également connecté à un port série asynchrone de type UART (Universal Asynchronous Receiver Transmitter) relié en sortie au micro-ordinateur 13, ainsi qu'au registre PREG du wattmètre 11, par l'intermédiaire de la liaison parallèle 14. La liaison 14 comprend ici 8 fils de données et 1 fil commande par lequel le microcontrôleur envoie un signal READP de lecture du registre PREG.

Le dispositif 12 fonctionne comme suit. Le signal échantillonné Us délivré par le convertisseur 26 est enregistré mot à mot (1 mot = 1 échantillon) dans la mémoire MEM1. Cette opération s'effectue sous le contrôle du circuit SEQ qui applique à la mémoire MEM1, après l'envoi de chaque impulsion d'échantillonnage SMPL, un signal de chargement LOAD1 et un signal de décalage SHIFT1. La mémoire MEM1 constitue ainsi une mémoire tournante de type FIFO ("first in first out") dans laquelle le signal échantillonné Us circule en permanence. La mémoire MEM1 définit ainsi une fenêtre d'observation dont la largeur est égale au produit de la période d'échantillonnage par le nombre d'échantillons qu'elle contient, soit ici une fenêtre de l'ordre de 2,56 microsecondes, suffisamment large pour capturer des impulsions d'une durée inférieure à la microseconde. En l'absence d'impulsion haute fréquence, le signal Us est proche de zéro en raison du filtrage passe-haut assuré par le transformateur 24, et le mot MBYT prélevé au milieu de la fenêtre temporelle est inférieur au seuil THR. Lorsqu'une impulsion est émise sur le réseau par un appareil électrique, le signal Us recopie le profil de l'impulsion et le mot MBYT devient supérieur au seuil THR. Le comparateur logique COMP délivre alors un signal DETECT au circuit SEQ et ce dernier décharge le contenu de la mémoire MEM1 dans la mémoire auxiliaire MEM2, puis envoie au microcontrôleur MC un signal PLSDET indiquant qu'une impulsion a été transférée dans la mémoire MEM2. Le microcontrôleur MC transfère alors le contenu de la mémoire MEM2 dans la mémoire de masse MEM3, au moyen du signal SHIFT2, en attribuant au signal enregistré la date de son enregistrement comme cela a déjà été indiqué plus haut. Parallèlement à ces opérations d'enregistrement d'impulsions, de nature aléatoire, le microcontrôleur MC lit toutes les secondes le registre PREG du wattmètre et enregistre les valeurs de puissance instantanée Pa, Pr dans la mémoire MEM3. Avantageusement, le microcontrôleur vérifie, après chaque enregistrement d'une impulsion, que la puissance Pa, Pr consommée sur le réseau avant et après l'impulsion présente une variation. Si le microcontrôleur ne constate aucune variation de puissance, il efface de la mémoire MEM3 l'impulsion enregistrée. Ainsi, des impulsions ne correspondant pas à des mises sous tension ou hors tension d'appareils ne sont pas enregistrées, et n'encombrent pas inutilement la mémoire MEM3. Comme on l'a indiqué plus haut, le contenu de la mémoire MEM3 est transféré à intervalles réguliers au micro-ordinateur 13 et la mémoire MEM3 est ensuite effacée.

En pratique, l'exploitation par le micro-ordinateur des données (impulsions détectées et puissance consommée) mémorisées par le circuit 12 nécessite l'élaboration d'une base de données indexée comportant, pour chaque appareil E1 à E9, la description de l'appareil, une ou plusieurs signatures représentatives des mises sous tension ou hors tension de l'appareil, une ou plusieurs valeurs de puissance active Pa et de puissance réactive Pr consommée, chaque valeur de puissance consommée étant associée à une signature. L'élaboration d'une telle base de données au cours d'une phase d'apprentissage est en soi comparable à celle du procédé de l'art antérieur, bien que les signatures des appareils soient ici prises en compte.

Un premier mode de réalisation de la phase d'apprentissage consiste à fournir au micro-ordinateur la liste des appareils connectés et leur puissance nominale théorique. Le micro-ordinateur enregistre dans un premier temps des couples signature/puissance consommée Pa, Pr sans savoir de quels appareils il s'agit, et associe ensuite à chaque appareil un couple signature/puissance consommée par rapprochement de la puissance consommée constatée et de la puissance nominale théorique. La valeur de puissance consommée mesurée par le wattmètre 11 remplace la valeur de puissance nominale théorique initialement fournie. Dans certains cas, le micro-ordinateur peut demander à l'utilisateur de procéder à des mises sous tension et hors tension, afin de lever des incertitudes.

Un autre mode d'apprentissage, plus conventionnel, consiste simplement à fournir au micro-ordinateur la liste des appareils connectés. Le micro-ordinateur demande ensuite à l'utilisateur de mettre sous tension et hors tension une ou plusieurs fois chaque appareil, pour enregistrement de la signature émise et de la puissance consommée par chaque appareil.

Il apparaîtra clairement à l'homme de l'art que la présente invention est susceptible de diverses variantes et mode de réalisation. Notamment, le dispositif 12 peut être équipé d'un détecteur d'impulsion analogique agencé à la sortie de l'amplificateur 1, en remplacement du comparateur COMP. Le wattmètre 11 peut être intégré dans le dispositif 12, sous la forme d'une carte électronique à circuit imprimé, l'ensemble ne nécessitant qu'une seule connexion au réseau. Le dispositif 12 peut être équipé d'un modem et transmettre directement à un serveur, via le réseau Internet, les données enregistrées dans la mémoire MEM3. Un tel serveur est à même de posséder une base de données importante élaborée à partir des informations communiquées par de nombreux dispositifs similaires installés chez d'autres abonnés, et peut assurer l'identification rapide des divers appareils à partir des signatures détectées ainsi que le calcul de la consommation détaillée. Dans une variante, les données sont transférées au serveur par le micro-ordinateur 13.

Par ailleurs, le procédé selon l'invention est applicable aux réseaux triphasés en prévoyant une détection d'impulsion et une mesure de puissance sur chaque phase du réseau.

Enfin, selon encore un autre mode de réalisation de la présente invention, les signaux haute fréquence formant une signature permettant l'identification de la mise sous tension ou hors tension d'un appareil électrique sont générés artificiellement au moyen d'un circuit générateur d'impulsions associé à l'appareil électrique. Ce mode de réalisation peut être envisagé lorsqu'un appareil électrique, par exemple une lampe de faible puissance, ne produit qu'une impulsion de faible amplitude. Le dispositif générateur d'impulsions peut être un simple circuit RC ou LC incorporé dans une prise électrique intercalaire agencée entre la prise mâle de l'appareil et une prise murale du secteur, ou un système à induction sans contact agencé sur le cordon d'alimentation de l'appareil. Le dispositif émet une impulsion particulière lorsque le courant apparaît ou disparaît dans la prise ou dans le cordon d'alimentation.

D'autre part, des amplificateurs d'impulsions du type répéteur peuvent être installés dans des sections de réseau de grande longueur dans lesquelles les impulsions s'atténuent avant d'atteindre le dispositif 12, par exemple des sections de réseau distribuant le courant dans une maison de plusieurs étages ayant un compteur unique au sous-sol.

Dans une variante plus élaborée, le dispositif générateur d'impulsions émet des signaux haute fréquence codés, par exemple une suite d'impulsions comprenant un nombre d'impulsions déterminé formant une signature unique. Un tel circuit générateur d'impulsions codées est à la portée de l'homme de l'art et peut être réalisé par exemple au moyen d'un oscillateur, d'un circuit logique et d'un petit transformateur. De plus, un tel circuit générateur d'impulsions codées peut être intégré dans tous types d'appareils électroménager par les fabricants eux-mêmes, pour un prix de revient réduit, en utilisant le transformateur du circuit d'alimentation des appareils pour envoyer le signal codé sur le réseau. En supposant que l'emploi de tels circuits générateurs d'impulsions soit généralisé, le procédé selon l'invention pourrait, à terme, être mis en oeuvre de façon entièrement numérique et ne reposer que sur une détection d'impulsions codées émises artificiellement. Il est également possible de combiner une détection de signaux parasites émis naturellement par certains appareils avec une détection de signaux codés émis par d'autres appareils équipés d'un circuit générateur d'impulsions.

## Revendications

1. Procédé de mesure de la consommation électrique d'au moins un élément électrique (E1-E9) connecté à un réseau de distribution d'électricité, comprenant une étape récurrente de mesure de la puissance instantanée globale (Pa, Pr) consommée sur le réseau et au moins une étape de détection d'une mise sous tension ou hors tension de l'élément électrique, procédé **caractérisé en ce que** l'étape de détection de la mise sous tension ou hors tension de l'élément électrique comprend une étape de détection d'au moins un signal électrique haute fréquence représentatif de l'élément électrique et indépendant de la consommation électrique de l'élément électrique, généré sur le réseau au moment de la mise sous tension ou la mise hors tension de l'élément électrique.

2. Procédé selon la revendication 1, **caractérisé en ce que** l'étape de détection du signal haute fréquence comprend une étape d'enregistrement (MEM1, MEM2, MEM3) du signal haute fréquence sous une forme numérique et une étape d'identification (13) du signal haute fréquence.

3. Procédé selon l'une des revendications 1 et 2, **caractérisé en ce que** l'étape de détection de la mise sous tension ou hors tension de l'élément électrique comprend en outre une étape de vérification consistant à comparer la variation de la puissance instantanée (Pa, Pr) consommée sur le réseau à la mise sous tension ou hors tension de l'élément électrique avec une valeur prédéterminée de puissance consommée par l'élément électrique.

4. Procédé selon la revendication 3, dans lequel l'étape de vérification comprend une étape de comparaison de la variation de puissance active (Pa) consommée sur le réseau avec une valeur prédéterminée de puissance active consommée par l'élément électrique, et une étape de comparaison de la variation de puissance réactive (Pr) consommée sur le réseau avec une valeur prédéterminée de puissance réactive consommée par l'élément électrique.

5. Procédé selon l'une des revendications 1 à 4 dans lequel l'élément électrique est un élément d'un appareil électrique comprenant une pluralité d'éléments électriques susceptibles d'être mis sous tension ou hors tension indépendamment les uns des autres.

6. Procédé selon l'une des revendications 1 à 5, dans lequel le signal électrique est généré naturellement par l'élément électrique, et constitue une impulsion électrique parasite.

7. Procédé selon l'une des revendications 1 à 6, dans lequel le signal électrique est produit par un circuit générateur de signaux haute fréquence associé à l'élément électrique, à la mise sous tension et/ou à la mise hors tension de l'élément électrique.

8. Dispositif de mesure (11, 12, 13) de la consommation électrique d'au moins un élément électrique connecté à un réseau de distribution d'électricité, comprenant des moyens (11) de mesure de la puissance instantanée globale consommée sur le réseau et des moyens de détection (12, 13) d'une mise sous tension ou hors tension de l'élément électrique, **caractérisé en ce que** les moyens de détection comprennent des moyens (12) de détection d'un signal électrique haute fréquence représentatif de l'élément électrique et indépendant de sa consommation électrique, généré sur le réseau au moment de la mise sous tension ou hors tension de l'élément électrique.

9. Dispositif de mesure selon la revendication 8, **caractérisé en ce qu'**il comprend des moyens (12, 27, MC, MEM3) pour enregistrer sous forme numérique des signaux haute fréquence apparaissant sur le réseau, en attribuant à chaque signal haute fréquence mémorisé la date et l'heure de sa détection.

10. Dispositif de mesure selon la revendication 9, **caractérisé en ce que** les moyens pour enregistrer sont agencés pour enregistrer également des valeurs de puissance instantanée globale (Pa, Pr) consommée sur le réseau mesurées par les moyens de mesure (11), en attribuant à chaque valeur mémorisée la date et l'heure de la mesure.

11. Dispositif de mesure selon l'une des revendications 9 et 10, **caractérisé en ce que** les moyens pour enregistrer sont agencés pour enregistrer continuellement dans une mémoire tampon (MEM1) le profil de la tension ou du courant dans le réseau après filtrage passe-haut (24), selon une fenêtre temporelle d'observation de largeur déterminée, et pour enregistrer le contenu de la mémoire tampon (MEM1) dans une mémoire de masse (12-1, MEM3) quand un signal haute fréquence apparaît dans la fenêtre d'observation.

12. Dispositif de mesure selon l'une des revendications 9 à 11, **caractérisé en ce que** les moyens pour enregistrer consistent en un dispositif d'enregistrement autonome (12) agencé pour délivrer sur une sortie le contenu de la mémoire de masse (12-1, MEM3) et effacer ensuite le contenu de la mémoire de masse, les moyens de mesure (11) étant intégrés dans le dispositif d'enregistrement autonome ou reliés à ce dernier par un canal de transmission de données (14).

13. Dispositif de mesure selon l'une des revendications 9 à 12, **caractérisé en ce qu'**il comprend un moyen de calcul (13) connecté aux moyens pour enregistrer (12), agencé pour identifier les signaux haute fréquence enregistrés et calculer la consommation de l'élément électrique à partir des dates de mise sous tension et/ou de mise hors tension de l'élément électrique et des variations de la puissance consommée.

14. Dispositif de mesure selon l'une des revendications 9 à 13, **caractérisé en ce que** les moyens de détection de la mise sous tension et de la mise hors tension de l'élément électrique comprennent un circuit d'émission de signaux haute fréquence associé à l'élément électrique, agencé pour générer un signal haute fréquence sur le réseau à la mise sous tension et/ou à la mise hors tension de l'élément électrique.

15. Dispositif de mesure selon l'une des revendications 9 à 14, comprenant au moins un dispositif répéteur connecté en un point déterminé du réseau, agencé pour amplifier un signal haute fréquence émis par un dispositif électrique éloigné des moyens de détection du signal haute fréquence.

## Patentansprüche

1. Verfahren zum Messen des Stromverbrauchs von mindestens einem elektrischen Element (E1-E9) in einem Elektrizitätsnetz, wobei das Verfahren einen wiederkehrenden Schritt des Messens der globalen Momentanleistung (Pa, Pr), die im Netz verbraucht wird, und mindestens einen Schritt zum Erfassen eines Unterspannungssetzens oder Außerspannungssetzens des elektrischen Elementes umfasst, wobei das Verfahren **dadurch gekennzeichnet ist, dass** der Schritt zum Erfassen des Unterspannungssetzens oder Außerspannungssetzens des elektrischen Elementes einen Schritt zum Erfassen von mindestens einem elektrischen Hochfrequenzsignal umfasst, das für das elektrische Element repräsentativ und von dem Stromverbrauch des elektrischen Elements unabhängig ist und im Netz zum Zeitpunkt des Unterspannungssetzens oder Außerspannungssetzens des elektrischen Elementes erzeugt wird.

2. Verfahren nach Anspruch 1, **dadurch gekennzeichnet, dass** der Schritt zum Erfassen des Hochfrequenzsignals einen Schritt zum Aufzeichnen (MEM1, MEM2, MEM3) des Hochfrequenzsignals in einer digitalen Form und einen Schritt zum Erkennen (13) des Hochfrequenzsignals umfasst.

3. Verfahren nach einem der Ansprüche 1 und 2, **dadurch gekennzeichnet, dass** der Schritt zum Erfassen des Unterspannungssetzens oder Außerspannungssetzens des elektrischen Elementes ferner einen Prüfschritt umfasst, der darin besteht, die Schwankung der Momentanleistung (Pa, Pr), die im Netz bei dem Unterspannungssetzen oder Außerspannungssetzen des elektrischen Elementes verbraucht wird, mit einem vorbestimmten Wert der vom elektrischen Element verbrauchten Leistung zu vergleichen.

4. Verfahren nach Anspruch 3, wobei der Prüfschritt einen Schritt zum Vergleichen der Schwankung der im Netz verbrauchten aktiven Leistung (Pa) mit einem vorbestimmten Wert der vom elektrischen Element verbrauchten aktiven Leistung und einen Schritt zum Vergleichen der Schwankung der im Netz verbrauchten reaktiven Leistung (Pr) mit einem vorbestimmten Wert der vom elektrischen Element verbrauchten reaktiven Leistung umfasst.

5. Verfahren nach einem der Ansprüche 1 bis 4, wobei das elektrische Element ein Element eines elektrischen Gerätes ist, welches mehrere elektrische Elemente umfasst, die geeignet sind, voneinander unabhängig unter Spannung oder außer Spannung gesetzt zu werden.

6. Verfahren nach einem der Ansprüche 1 bis 5, wobei das elektrische Signal auf natürliche Weise durch das elektrische Element erzeugt wird und einen elektrischen Störimpuls darstellt.

7. Verfahren nach einem der Ansprüche 1 bis 6, wobei das elektrische Signal durch einen Kreis erzeugt wird, der Hochfrequenzsignale erzeugt und mit dem elektrischen Element, dem Unterspannungssetzen und/oder dem Außerspannungssetzen des elektrischen Elementes verbunden ist.

8. Vorrichtung (11, 12, 13) zum Messen des Stromverbrauchs von mindestens einem elektrischen Element in einem Elektrizitätsnetz, welche Mittel (11) zum Messen der globalen im Netz verbrauchten Momentanleistung und Mittel (12, 13) zum Erfassen eines Unterspannungssetzens oder Außerspannungssetzens des elektrischen Elementes umfasst, **dadurch gekennzeichnet, dass** die Mittel zum Erfassen Mittel (12) zum Erfassen eines elektrischen Hochfrequenzsignals umfassen, welches für das elektrische Element repräsentativ und von dessen Stromverbrauch unabhängig ist und das im Netz zum Zeitpunkt des Unterspannungssetzens oder Außerspannungssetzens des elektrischen Elementes erzeugt wird.

9. Vorrichtung zum Messen nach Anspruch 8, **dadurch gekennzeichnet, dass** sie Mittel (12, 27, MC, MEM3) zum digitalen Aufzeichnen der Hochfrequenzsignale, die im Netz erscheinen, umfasst, wobei sie jedem gespeicherten Hochfrequenzsignal das Datum und die Uhrzeit seiner Erfassung zuordnet.

10. Vorrichtung zum Messen nach Anspruch 9, **dadurch gekennzeichnet, dass** die Mittel zum Aufzeichnen angeordnet sind, um auch Werte der globalen, im Netz verbrauchten Momentanleistung (Pa, Pr) aufzuzeichnen, die durch die Mittel (11) zum Messen gemessen werden, wobei jedem gespeicherten Wert das Datum und die Uhrzeit der Messung zugeordnet wird.

11. Vorrichtung zum Messen nach einem der Ansprüche 9 und 10, **dadurch gekennzeichnet, dass** die Mittel zum Aufzeichnen angeordnet sind, um das Profil der Spannung oder des Stroms im Netz nach Hochpassfilterung (24) gemäß eines zeitlichen Beobachtungsfensters von bestimmter Breite fortlaufend in einem Pufferspeicher (MEM1) aufzuzeichnen, und um den Inhalt des Pufferspeichers (MEM1) in einem Massespeicher (12-1, MEM3) aufzuzeichnen, wenn ein Hochfrequenzsignal im Beobachtungsfenster erscheint.

12. Vorrichtung zum Messen nach einem der Ansprüche 9 bis 11, **dadurch gekennzeichnet, dass** die Mittel zum Aufzeichnen aus einer autonomen Aufzeichnungsvorrichtung (12) bestehen, welche angeordnet ist, um über einen Ausgang den Inhalt des Massespeichers (12-1, MEM3) bereitzustellen und in der Folge den Inhalt des Massespeichers zu löschen, wobei die Mittel (11) zum Messen in die autonome Aufzeichnungsvorrichtung integriert oder mit dieser über einen Datenübertragungskanal (14) verbunden sind.

13. Vorrichtung zum Messen nach einem der Ansprüche 9 bis 12, **dadurch gekennzeichnet, dass** diese ein Berechnungsmittel (13) umfasst, welches mit den Aufzeichnungsmitteln (12) verbunden und angeordnet ist, um die aufgezeichneten Hochfrequenzsignale zu erkennen und den Verbrauch des elektrischen Elementes ausgehend von den Daten für das Unterspannungssetzen und/oder das Außerspannungssetzen des elektrischen Elementes und den Schwankungen der verbrauchten Leistung zu berechnen.

14. Vorrichtung zum Messen nach einem der Ansprüche 9 bis 13, **dadurch gekennzeichnet, dass** die Mittel zum Erfassen des Unterspannungssetzens und Außerspannungssetzens des elektrischen Elementes einen Kreis zur Ausgabe von Hochfrequenzsignalen umfassen, der mit dem elektrischen Element verbunden und angeordnet ist, um beim Unterspannungssetzen und/oder Außerspannungssetzen des elektrischen Elementes ein Hochfrequenzsignal im Netz zu erzeugen.

15. Vorrichtung zum Messen nach einem der Ansprüche 9 bis 14, welche mindestens eine Verstärkervorrichtung umfasst, die an einem bestimmten Punkt des Netzes angeschlossen und angeordnet ist, um ein Hochfrequenzsignal zu verstärken, das von einer elektrischen Vorrichtung ausgegeben wird, welche von den Mitteln zum Erfassen des Hochfrequenzsignals entfernt ist.

## Claims

1. Method of measuring the consumption of at least one electric element (E1-E9) connected to an electricity distribution network, comprising a recurrent step for measuring the total instantaneous power (Pa, Pr) consumed in the network and at least one step for detecting when the electric element is switched on or off, the method being **characterised in that** the step that detects when the electric element is switched on or off comprises a step for detecting at least one high frequency electrical signal representative of the electric element and independent of the consumption of the electric element, generated in the network when the electric element is switched on or off.

2. Method according to claim 1, **characterised in that** the stage for detecting the high frequency signal comprises a step (MEM1, MEM2, MEM3) for recording the high frequency signal in digital form and a step (13) for identifying the high frequency signal.

3. Method according to one of claims 1 and 2, **characterised in that** the step for detecting when the electric element is switched on or off further comprises a checking stage consisting of comparing the variation in instantaneous power (Pa, P4) consumed in the network when the electric element is switched on or off with a predetermined value of the power consumed by the electric element.

4. Method according to claim 3, in which the checking stage comprises a step for comparing the variation in active power (Pa) consumed in the network with a predetermined value of active power consumed by the electric element, and a step for comparing the variation in reactive power (Pr) consumed in the network with a predetermined value of reactive power consumed by the electric element.

5. Method according to one of claims 1 to 4, in which the electric element is an element for an electrical apparatus comprising a plurality of electric elements which may be switched on or off independently of each other.

6. Method according to one of claims 1 to 5, in which the electrical signal is naturally generated by the electric element and forms a parasitic electrical impulse.

7. Method according to one of claims 1 to 6, in which the electrical signal is produced by a circuit generating a high frequency signal, connected to the electric element when the electric element is switched on and/or off.

8. Apparatus (11, 12, 13) for measuring the electrical consumption of at least one electric element connected to an electricity distribution network, comprising means (11) for measuring the total instantaneous power consumed in the network and means (12, 13) for detecting when the electric element is switched on or off, **characterised in that** the detection means comprise means (12) for detecting a high frequency electrical signal representative of the electric element and independent of its electrical consumption, generated in the network when the electric element is switched on or off.

9. Measuring apparatus according to claim 8, **characterised in that** it comprises means (12, 27, MC MEM3) for recording, in digital form, high frequency signals appearing in the network, by attributing to each recorded high frequency signal the date and time of its detection.

10. Measuring apparatus according to claim 9, **characterised in that** the recording means are also used to record the values of total instantaneous power (Pa, Pr) consumed in the network, measured by the measuring means (11), by attributing to each recorded value the date and time of its measurement.

11. Measuring apparatus according to one of claims 9 and 10, **characterised in that** the recording means are used to continuously record, in a buffer (MEM1), the voltage or current profile in the network after high-pass filtration (24) according to a temporal observation window of determined size, and to record the contents of the buffer (MEM1) in a mass memory (12-1, MEM3) when a high frequency signal appears in the observation window.

12. Measuring apparatus according to one of claims 9 to 11, **characterised in that** the recording means consist of an autonomous recording device (12) used to deliver, at an output, the contents of the mass memory (12-1, MEM3) and to then delete the contents from the mass memory, the measuring means (11) being integrated in the autonomous recording device or connected to the latter by a data transmission channel (14).

13. Measuring apparatus according to one of claims 9 to 12, **characterised in that** it comprises calculating means (13), connected to the recording means (12), used to identify the recorded high frequency signals and to calculate the consumption of the electric element from the dates it was switched on and/or off and the variations in consumed power.

14. Measuring apparatus according to one of claims 9 to 13, **characterised in that** the means for detecting when the electric element is switched on and off comprise a circuit for transmitting high frequency signals which is connected to the electric element and used to generate a high frequency signal in the network when the electric element is switched on and/or off.

15. Measuring apparatus according to one of claims 9 to 14, comprising at least one repeater device, connected at a determined point in the network, used to amplify a high frequency signal emitted by an electrical device away from the means for detecting the high frequency signal.
